# EUROPÄISCHE PATENTSCHRIFT

(11) **EP 2 088 647 B1**
(45) Veröffentlichungstag und Bekanntmachung des Hinweises auf die Patenterteilung: **19.09.2012**
(21) Anmeldenummer: 09001511.6
(22) Anmeldetag: 04.02.2009
(51) Int. Cl.: H01R 13/514, H04Q 1/14, H05K 7/14, H05K 5/02

(54) **Netzwerkmodul, für den Einbau in eine Verteilerperipherie**
Network module for installation in a distributor periphery
Module réseau pour l'intégration dans une périphérie de distributeur

(30) Priorität: 08.02.2008 DE 102008008258
(43) Veröffentlichungstag der Anmeldung: 12.08.2009
(73) Patentinhaber: LEONI Kerpen GmbH, 52224 Stolberg (DE)
(72) Erfinder: Wollenweber Heinz,, 52080 Aachen (DE)
(74) Vertreter: Maxton Langmaack & Partner

(56) Entgegenhaltungen:
- EP-A1- 1 176 673
- EP-A2- 1 555 727
- DE-B3- 10 313 358
- DE-U1- 20 014 186
- DE-U1- 29 920 712
- US-A1- 2004 190 232

## Beschreibung

Die Erfindung betrifft ein Netzwerkmodul für den Einbau in eine Verteilerperipherie, wobei das Netzwerkmodul mit zumindest einer Datenbuchse ausgestattet ist, gemäß des Oberbegriffes des Anspruches 1.

Netzwerkmodule zum Einbau in Verteilerperipherien sind allgemein bekannt. So werden beispielsweise Verteilermodule, die sogenannte Rangierfelder bzw. Patchfelder bilden, in Netzwerkschränke oder Racks eingebaut. Für den Einbau werden Verlegekabel bis zu dem Netzwerkschrank geführt und meist von hinten in diesen eingeführt und nach vorne hin aus dem Netzwerkschrank herausgezogen. Daraufhin werden die Adern des Verlegekabels an das Netzwerkmodul konfektioniert. Das Netzwerkmodul wird dann von vorne in den Netzwerkschrank eingeführt und festgeschraubt. Dieser Arbeitsvorgang ist sehr Zeitaufwendig und führt zu teuren Ausfallzeiten.

Aus dem "Design Guide Rechenzentrumsverkabelung" der Firma AMP-Connect von 2005 geht hervor, dass eine Steckverbindung zwischen dem Verlegekabel und einem Verteilermodul den Arbeitsaufwand reduziert. Jedoch ist weiterhin das Durchziehen des Verlegekabels von hinten durch einen Einbaurahmen sowie das Einstecken des Steckers in das Verteilerelement vor dem Netzwerkschrank notwendig. Hiernach muss dann das Verteilerelement von vorne in den Einbaurahmen des Netzwerkschrankes eingeführt und festgeschraubt werden.

Die DE 299 20 712 U1 zeigt ein Netzwerkmodul gemäß des Oberbegriffes des Anspruchs 1.

Aufgabe der Erfindung ist es, eine Vorrichtung sowie ein Verfahren zur Verfügung zu stellen, das die Errichtung einer Netzwerkarchitektur erleichtert und Ausfallzeiten durch Installationsarbeiten reduziert.

Diese Aufgabe wird erfindungsgemäß gelöst durch ein Netzwerkmodul gemäß Anspruch 1, ein Verfahren zur Installation eines Netzwerkmoduls nach Anspruch 11, einem Verfahren zur Herstellung eines Netzwerkmodulsystems nach Anspruch 14 und einer Verwendung eines Netzwerkmodulsystems nach Anspruch 15.

Es wird ein Netzwerkmodul für den Einbau in eine Verteilerperipherie vorgeschlagen, wobei das Netzwerkmodul mit zumindest einer, vorzugsweise mit zumindest zwei Datenbuchsen ausgestattet ist. Das Netzwerkmodul weist zumindest ein Verlegekabel auf, welches vorkonfektioniert an dem Netzwerkmodul angebracht ist.

Unter der Verteilerperipherie kann ein Netzwerkschrank, ein Serverschrank, ein Elektronikgehäuse, ein Servergehäuse, ein Wandgehäuse, ein Netzwerkständer, ein Verteilerrahmen und/oder ein sogenanntes Rack verstanden werden. Auch andere Einrichtungen zur Aufnahme von Netzwerkmodulen sind unter dem Begriff Verteilerperipherie erfasst. Insbesondere kann die Verteilerperipherie zumindest einen Einbaurahmen aufweisen bzw. es kann zumindest ein Einbaurahmen in die Verteilerperipherie eingebaut werden. Der Einbaurahmen kann beispielsweise in der Größen 10 Zoll oder 19 Zoll ausgeführt sein, jedoch sind auch weitere Größen vorgesehen. Insbesondere ist der Einbaurahmen an die Größe des Netzwerkmoduls angepasst.

Vorteil der vorgeschlagenen Ausgestaltung ist, dass das Netzwerkmodul fertig konfektioniert und vorzugsweise seitens des Herstellers getestet, mit dem Verlegekabel verbunden ist. Eine Konfektionierung durch den Benutzer ist somit nicht mehr notwendig. Dies spart viel Zeit bei einem Einbau des Netzwerkmoduls in die Verteilerperipherie. Des Weiteren braucht das Verlegekabel keine Überlänge aufweisen, da das Netzwerkmodul nicht mehr vor der Verteilerperipherie an das Verlegekabel konfektioniert wird und somit nicht mehr aus der Verteilerperipherie herausgezogen werden muss.

In einer ersten Ausgestaltung ist das Netzwerkmodul steckerlos mit dem Verlegekabel verbunden. Insbesondere ist das Verlegekabel durch Löten, Schrauben, Klemmen, Schneidklemmen und/oder Kleben an das Netzwerkmodul vorkonfektioniert. Auch andere Arten der steckerlosen Konfektionierung sind in weiteren Ausgestaltungen vorgesehen. Durch die Vermeidung eines Steckers wird die Übertragungsqualität erheblich verbessert.

Weiterhin ist eine nicht erfindungsgemäße Ausgestaltung vorgesehen, wobei zumindest eine Ader vorzugsweise zumindest ein Aderpaar des Verlegekabels direkt oder indirekt mit zumindest einer Datenbuchse in Verbindung steht.

Das Netzwerkmodul ist in einer weiteren Ausführung zugfest mit dem Verlegekabel verbunden. Insbesondere weist das Netzwerkmodul eine Zugentlastung für das Verlegekabel auf. Auch ist in einer weiteren Ausgestaltung zumindest ein Zugentlastungselement des Verlegekabeis mit dem Netzwerkmodul verbunden. Dieses kann insbesondere an das Netzwerkmodul geknotet, verklebt, vergossen, geschraubt und/oder geklemmt sein.

Durch die zugfeste Verbindung zwischen dem Netzwerkmodul und dem Verlegekabel wird gewährleistet, dass das Verlegekabel zusammen mit dem Netzwerkmodul beispielsweise in eine Kabeltrasse oder eine Verteilerperipherie eingebracht werden kann. Insbesondere kann somit das Verlegekabel mittels des Netzwerkmoduls eingezogen werden. So ist in einer weiteren Ausgestaltung vorgesehen, dass das Netzwerkmodul eine Einziehhilfe aufweist. Die Einziehhilfe kann insbesondere einem Griff oder einer Schlaufe aufweisen. Insbesondere kann die Einziehhilfe von dem Netzwerkmodul entfernbar sein. Wenn das Netzwerkmodul installiert ist, kann somit die Einziehhilfe entfernt werden, da diese bei einem Betrieb des Netzwerkmoduls nicht benötigt wird. In einer Ausgestaltung ist die Einziehhilfe wiederverwendbar und insbesondere für verschiedenartige Netzwerkmodule verwendbar bzw. an diese anbringbar.

Das Netzwerkmodul ist in einer Ausführungsform derart ausgestattet, dass dieses in einem Einbaurahmen einrastbar ist. Der Einbaurahmen kann insbesondere vor der Installation des Netzwerkmoduls in die Verteilerperipherie eingebracht werden. Es ist somit möglich, das Netzwerkmodul von einer Kabeltrasse bzw. einer Kabelführung kommend in die Verteilerperipherie einzuziehen und in den Einbaurahmen einzurasten. Eine Installation von einer Vorderseite der Verteilerperipherie ist somit nicht notwendig. Auch ist eine weitere Version vorgesehen, bei der das Netzwerkmodul in den Einbaurahmen schraubbar oder klemmbar ist. Insbesondere ist vorgesehen, dass die Verbindung zwischen Netzwerkmodul und Einbaurahmen eine lösbare Verbindung ist.

Das Netzwerkmodul unterstützt in einer weiterführenden Ausgestaltung eine Spannungsversorgung über das Verlegekabel. Insbesondere wird ein sogenanntes "Power over E-thernet" durch das Netzwerkmodul unterstützt. In einer weiteren Fortbildung ist das Netzwerkmodul mit dem IEEE-Standard 802.3af und/oder IEEE 802.3 at "DTE Power over MDI" konform.

Das Netzwerkmodul ist in einer Version für die Anbindung von Kupferleitungen ausgelegt. In einer weiteren Ausgestaltung ist das Netzwerkmodul für eine Anbindung von Lichtwellenleitern ausgelegt. Auch ist eine Version vorgesehen, die sowohl Kupferleitungen als auch Lichtwellenleitungen unterstüzt. Auch sind Ausgestaltungen vorgesehen, die ausgelegt sind für eine Anbindung von Goldleitungen, Silberleitungen, Supraleiterleitungen und/oder anderen Leitern aus Metallen, Keramiken, Halbleitern, Fullerenen und/oder deren Legierungen.

In einer Version weist das Netzwerkmodul ein Verteilersegment auf. Insbesondere bildet wenigstens ein Netzwerkmodul ein Rangierfeld, das auch Patchfeld genannt wird. In einer weiteren Ausgestaltung weist das Netzwerkmodul einen Medienkonverter auf. Insbesondere ist der Medienkonverter dazu verwendbar elektrische Signale in Lichtwellensignale und/oder umgekehrt zu konvertieren. Das Netzwerkmodul kann auch andere - hier nicht weiter erläuterte - Netzwerkkomponenten aufweisen.

Ein weiterer Gedanke der Erfindung ist ein Verfahren zur Installation eines vorkonfektionierten Netzwerkmoduls, wobei ein Verlegekabel, das an dem Netzwerkmodul angeordnet ist, mittels des Netzwerkmoduls in eine Kabeltrasse eingezogen wird.

Unter dem Begriff Kabeltrasse ist insbesondere ein Kabelkanal, ein Doppelboden bzw. Unterboden oder eine anders gestaltete Kabelführung zu verstehen.

Eine erste Ausgestaltung des Verfahrens sieht vor, dass das Verlegekabel, das an dem Netzwerkmodul angeordnet ist, durch ziehen an dem Netzwerkmodul in eine Verteilerperipherie eingezogen wird. Insbesondere wird das Netzwerkmodul mittels einer Einziehhilfe in die Kabeltrasse und/oder eine Verteilerperipherie eingebracht. Ein solches Verfahren erlaubt es, das Verlegekabel inklusive dem Netzwerkmodul in eine Netzwerkstruktur einzubringen. Insbesondere wird hierdurch sichergestellt, dass das Verlegekabel eindeutig dem Netzwerkmodul zugeordnet ist. Auch ist durch das vorgestellte Verfahren eine Arbeitserleichterung gegeben, da das Netzwerkmodul nicht mehr konfektioniert werden muss.

Eine weitere Ausgestaltung sieht vor, dass das Netzwerkmodul an einem Einbaurahmen befestigt wird, der an einer Verteilerperipherie angeordnet ist. Dieser Einbaurahmen kann ein Standardeinbaurahmen sein. Es ist jedoch in einer Ausgestaltung vorgesehen, dass der Einbaurahmen speziell für das Netzwerkmodul ausgestaltet ist. Insbesondere unterstützt der Einbaurahmen, dass das Netzwerkmodul von einer Rückseite der Verteilerperipherie aus eingebaut werden kann. In einer weiteren Ausgestaltung rastet das Netzwerkmodul in den Einbaurahmen ein.

Ein weiterer Gedanke der Erfindung ist die Herstellung eines Netzwerkmodulsystems, wobei ein Verlegekabel an zumindest einem Kabelende steckerlos mit einem Netzwerkmodul verbunden wird. Eine derartige werksseitige Konfektionierung erlaubt eine gleichbleibend hohe Qualität, Montagefehler werden vermieden. Insbesondere durch die werksseitige Prüfung des vorkonfektionierten Netzwerkmoduls wird der Messaufwand bei der Abnahme der Verkabelung deutlich reduziert. Das heißt, der Zeitaufwand für Montage, Messungen und Fehlerbehebung vor Ort wird deutlich reduziert, der Forderung nach "Zero Downtime" im Rechenzentrum kommt man gleich mehrere Schritte näher.

In einer nicht erfindungsgemäßen Ausgestaltung wird zumindest eine Ader, vorzugsweise ein Aderpaar des Verlegekabels direkt oder indirekt mit einer Buchse des Netzwerkmoduls verbunden. Es ist insbesondere in einer weiteren Ausführung vorgesehen, dass ein Medienkonverter zwischen das Aderpaar des Verlegekabels und die Buchse geschaltet wird.

Ein weiterer Gedanke der Erfindung ist die Verwendung eines Netzwerkmodulsystems mit einem Verlegekabel, an dessen zumindest einem Ende ein Netzwerkmodulsystem steckerlos angeordnet ist. Dieses Netzwerkmodulsystem wird zur Einrichtung einer Netzwerkarchitektur verwendet. In einer weiteren Version könnte das Netzwerkmodulsystem in einem Rechenzentrum verwendet werden. Auch könnte vorgesehen sein, dass das Netzwerkmodulsystem im sogenannten Office-, Industrie- oder Home-Bereich verwendet wird.

Weitere vorteilhafte Ausgestaltungen gehen aus den nachfolgenden Zeichnungen hervor. Die dort dargestellten Weiterbildungen sind jedoch nicht beschränkend auszulegen, sondern die dort beschriebenen Merkmale können untereinander und/oder mit den oben beschriebenen Merkmalen zu weiteren Ausgestaltungen kombiniert werden. In der nachfolgenden Figurenbeschreibung wird exemplarisch für ein Netzwerkmodul ein Verteilersegment beschrieben. Es versteht sich, dass die beschriebenen Merkmale auch auf weitere Netzwerkmodule insbesondere Medienkonverter angewendet werden können. Gleiche Teile oder Teile mit gleicher Funktion weisen im Folgenden die gleichen Bezugszeichen auf. Es zeigen:
- Fig. 1: ein als Verteilersegment ausgestaltetes Netzwerkmodul;
- Fig. 2: ein Netzwerkmodul in einer Schnittansicht; und
- Fig. 3: eine schematische Darstellung eines Einbaus eines Netzwerkmodulsystems.

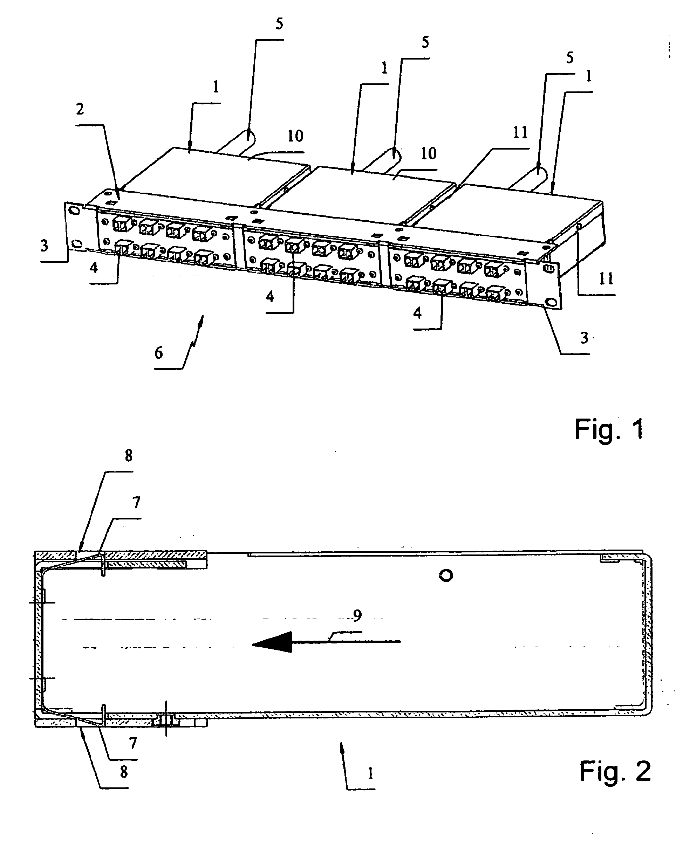

Fig. 1 zeigt drei als Verteilersystem ausgestaltete Netzwerkmodule 1, die in einen Einbaurahmen 2 eingebaut sind. Der Einbaurahmen 2 ist mittels Flanschplatten 3 insbesondere schraubbar in eine hier nicht dargestellte Verteilerperipherie einbringbar. Weiterhin weist das Verteilersystem Buchsenöffnungen zur Aufnahme von Rangierbuchsen 4 auf. Ein Verlegekabel 5 ist in das Verteilersystem eingebracht. Insbesondere spaltet sich das Verlegekabel 5 innerhalb des Verteilersystems in einzelne Aderpaare auf, die jeweils an die Rangierbuchsen 4 konfektioniert sind. Die Rangierbuchsen 4 sind mittels Befestigungsmitteln an die Buchsenöffnungen angeordnet.

In einer Ausgestaltung ist es vorgesehen, dass das Netzwerkmodul eine Verkleidung 10 aufweist. Diese kann beispielsweise mittels Befestigungsmitteln 11 an das dem Netzwerkmodul 1 befestigt werden.

Ist das Netzwerkmodul 1 als Medienkonverter ausgestattet, so ist innerhalb des Netzwerkmoduls 1 zumindest eine aktive Komponente, welche Signale beispielsweise von Lichtwellenleitern auf Kupferleiter konvertiert.

So ist es in einer Ausgestaltung vorgesehen, dass in einen Einbaurahmen beispielsweise drei Verteilersegmente angeordnet sind. Diese bilden ein sogenanntes Rangierfeld 6. Ein Rangierfeld kann auch durch ein einziges, zwei oder mehr als drei Verteilersegmente gebildet werden, die insbesondere in mehr als einem Einbaurahmen angeodnet sind. Weiterhin ist in einer weiteren Ausgestaltung vorgesehen, dass zumindest ein Netzwerkmodul, dass in dem Einbaurahmen angeordnet ist, ein Medienkonverter ist.

Fig. 2 zeigt ein Netzwerkmodul 1 in einer Schnittansicht. Es ist zu erkennen, dass das Netzwerkmodul 1 in den Einbaurahmen 2 eingerastet ist. Hierzu weist das Netzwerkmodul zumindest eine Federraste 7 auf, die in eine Aussparung 8 des Einbaurahmens 2 einrastet. Die Federraste 7 kann mit dem Netzwerkmodul 1 mittels eines Befestigungsmittels verbunden sein. Es ist in weiteren Ausgestaltungen auch vorgesehen, dass die Federraste 7 an das Netzwerkmodul 1 geklebt, geklemmt, geschweißt und/oder gelötet ist.

Durch die Einrastung des Netzwerkmoduls 1 in den Einbaurahmen 2 ist eine wesentliche Arbeitserleichterung erreicht. Das Netzwerkmodul 1 wird lediglich in Pfeilrichtung 9 in den Einbaurahmen 2 geschoben, wobei in einer bestimmten Position die Federraste 7 in die Aussparung 8 des Einbaurahmens 2 einrastet. Ein Verschrauben des Netzwerkmoduls 1 mit dem Einbaurahmen 2, wie dies Stand der Technik ist, ist nicht erforderlich. In einer Ausgestaltung ist diese rastende Verbindung lösbar.

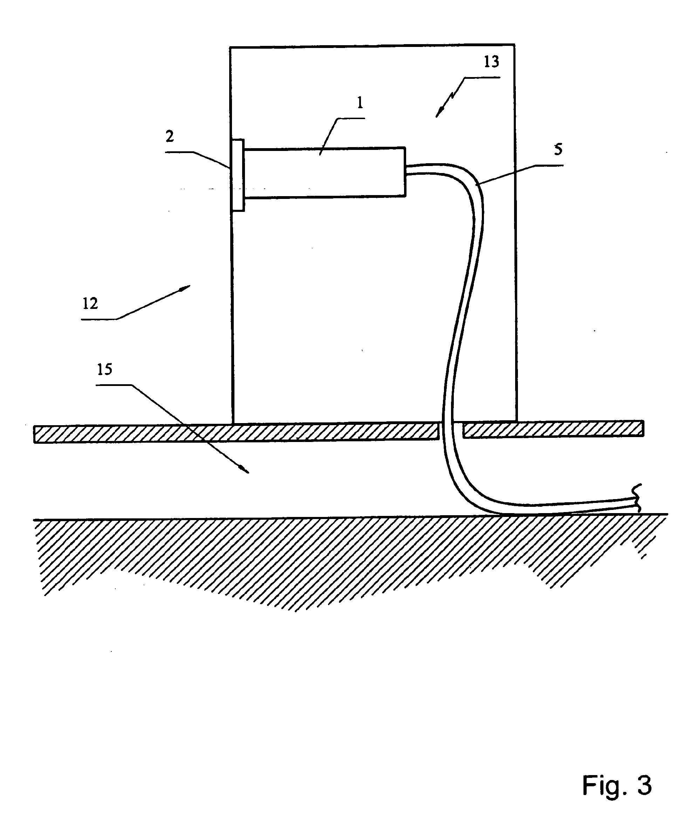

Fig. 3 zeigt eine schematische Ansicht eines in eine Verteilerperipherie 12 eingebauten Netzwerkmodulsystems 13. Das Netzwerkmodulsystem weist ein Netzwerkmodul 1 und ein Verlegekabel 5 auf. Das Netzwerkmodulsystem 13 ist in einem Doppelboden 15 beispielsweise eines Rechenzentrums verlegt und mit einem Ende in die Verteilerperipherie 12 eingeführt. Das Netzwerkmodul 1 des Netzwerkmodulsystems 13 ist von einer Innenseite der Verteilerperipherie 12 in einen Einbaurahmen 2 eingeführt und dort befestigt, vorzugsweise eingerastet. Eine Überlänge des Verlegekabels 5 ist für den gezeigten Einbau nicht notwendig, da das Netzwerkmodulsystem 13 vorkonfektioniert sowohl in den Doppelboden 15 als auch in die Verteilerperipherie 12 eingebracht wird und das Netzwerkmodul 1 von einer Innenseite der Verteilerperipherie aus in den Einbaurahmen 2 eingebracht wird.

## Patentansprüche

1. Netzwerkmodul (1) für den Einbau in eine Verteilerperipherie (12), wobei das Netzwerkmodul (1) mit zumindest einer Datenbuchse (4) ausgestattet ist und das Netzwerkmodul (1) zumindest ein Verlegekabel (5) aufweist, welches vorkonfektioniert an dem Netzwerkmodul (1) angebracht ist, **dadurch gekennzeichnet, dass** das Netzwerkmodul (1) von einer Kabeltrasse oder einer Kabelführung kommend in die Verteilerperipherie (12) einziehbar ist.

2. Netzwerkmodul (1) nach Anspruch 1, **dadurch gekennzeichnet, dass** das Netzwerkmodul (1) steckerlos mit dem Verlegekabel (5) verbunden ist.

3. Netzwerkmodul (1) nach einem der vorhergehenden Ansprüche, **dadurch gekennzeichnet, dass** das Netzwerkmodul (1) zugfest mit dem Verlegekabel (5) verbunden ist.

4. Netzwerkmodul (1) nach einem der vorhergehenden Ansprüche, **dadurch gekennzeichnet, dass** das Netzwerkmodul (1) eine Einziehhilfe aufweist.

5. Netzwerkmodul (1) nach einem der vorhergehenden Ansprüche mit einem Einbaurahmen (2), **dadurch gekennzeichnet, dass** das Netzwerkmodul (1) in den Einbaurahmen (2) einrastbar und/oder verschraubbar ist.

6. Netzwerkmodul (1) nach einem der vorhergehenden Ansprüche, **dadurch gekennzeichnet, dass** das Netzwerkmodul (1) eine Spannungsversorgung über das Verlegekabel (5) unterstützt.

7. Netzwerkmodul (1), nach einem der vorhergehenden Ansprüche, **dadurch gekennzeichnet, dass** das Netzwerkmodul (1) Kupferleiter und/oder Lichtwellenleiter aufnimmt.

8. Netzwerkmodul (1) nach einem der vorhergehenden Ansprüche, **dadurch gekennzeichnet, dass** das Netzwerkmodul (1) ein Verteilersegment aufweist.

9. Netzwerkmodul (1) nach einem der vorhergehenden Ansprüche, **dadurch gekennzeichnet, dass** wenigstens ein Netzwerkmodul (1) ein Rangierfeld bildet.

10. Netzwerkmodul (1) nach einem der vorhergehenden Ansprüche, **dadurch gekennzeichnet, dass** das Netzwerkmodul (1) einen Medienkonverter aufweist.

11. Verfahren zur Installation eines vorkonfektionierten Netzwerkmoduls (1), wobei ein Verlegekabel (5), das an dem Netzwerkmodul (1) angeordnet ist, durch ziehen an dem Netzwerkmodul (1) in eine Kabeltrasse eingezogen wird.

12. Verfahren nach Anspruch 11, **dadurch gekennzeichnet, dass** das Verlegekabel (5), das an dem Netzwerkmodul (1) angeordnet ist, durch ziehen an dem Netzwerkmodul (1) in eine Verteilerperipherie (12) eingezogen wird.

13. Verfahren nach Anspruch 11 oder 12, **dadurch gekennzeichnet, dass** das Netzwerkmodul (1) mittels einer an dem Netzwerkmodul (1) angeordneten Einziehhilfe in die Kabeltrasse und/oder Verteilerperipherie(12) eingezogen wird.

14. Verfahren zur Herstellung eines Netzwerkmodulsystems (13), wobei ein Verlegekabel (5) an zumindest einem Kabelende steckerlos mit einem Netzwerkmodul (1) nach einem der Ansprüche 1 bis 10 verbunden wird.

15. Verwendung eines Netzwerkmodulsystems (13), mit einem Verlegekabel (5), an dessen zumindest einem Ende des Verlegekabels (5) ein Netzwerkmodul (1) nach einem der Ansprüche 1 bis 10 steckerlos angeordnet ist, wobei das Netzwerkmodul eine Einziehhilfe aufweist, zur Errichtung einer Netzwerkarchitektur.

## Claims

1. Network module (1) for installation in a distributor periphery (12), which network module (1) is equipped with at least one data connector (4), and the network module (1) has at least one installation cable (5) which is mounted on the network module (1) in a prefabricated arrangement, **characterised in that** the network module (1) can be pulled from a cable route or cable run running into the distributor periphery (12)

2. Network module (1) as claimed in claim 1, **characterised in that** the network module (1) is connected to the installation cable (5) without a plug connector.

3. Network module (1) as claimed in one of the preceding claims, **characterised in that** the network module (1) is connected to the installation cable (5) so that it cannot be pulled off.

4. Network module (1) as claimed in one of the preceding claims, **characterised in that** the network module (1) has a pull-in aid.

5. Network module (1) as claimed in one of the preceding claims with a mounting frame (2), **characterised in that** the network module (1) can be latched and/or screwed into the mounting frame (2) .

6. Network module (1) as claimed in one of the preceding claims, **characterised in that** the network module (1) boosts a voltage supply via the installation cable (5).

7. Network module (1) as claimed in one of the preceding claims, **characterised in that** the network module (1) accommodates copper conductors and/or optical guides.

8. Network module (1) as claimed in one of the preceding claims, **characterised in that** the network module (1) has a distributor segment.

9. Network module (1) as claimed in one of the preceding claims, **characterised in that** at least one network module (1) forms a plug board.

10. Network module (1) as claimed in one of the preceding claims, **characterised in that** the network module (1) has a media convertor.

11. Method of installing a prefabricated network module (1), whereby an installation cable (5) disposed on the network module (1) is pulled into a cable route by pulling on the network module (1).

12. Method as claimed in claim 11, **characterised in that** the installation cable (5) disposed on the network module (1) is pulled into a distributor periphery (12) by pulling on the network module (1) .

13. Method as claimed in claim 11 or 12, **characterised in that** the network module (1) is pulled into the cable route and/or distributor periphery (12) by means of a pull-in aid disposed on the network module (1).

14. Method of producing a network module system (13) whereby an installation cable (5) is connected to a network module (1) as claimed in one of claims 1 to 10 by at least one cable end without a plug connector.

15. Use of a network module system (13) with an installation cable (5) on which a network module (1) as claimed in one of claims 1 to 10 is disposed by means of at least one end of the installation cable (5) without a plug connector, and the network module has a pull-in aid for setting up a network architecture.

## Revendications

1. Module de réseau (1) pour le montage dans une périphérie de répartiteur (12), le module de réseau (1) étant équipé d'au moins une douille de données (4) et le module de réseau (1) présente au moins un câble de pose (5), qui est placé de façon pré-confectionnée sur le module de réseau (1), **caractérisé en ce que** le module de réseau (1) peut être tiré depuis un chemin de câble ou un guide câble dans la périphérie du répartiteur (12).

2. Module de réseau (1) selon la revendication 1, **caractérisé en ce que** le module de réseau (1) est relié sans fiche au câble de pose (5).

3. Module de réseau (1) selon l'une des revendications précédentes, **caractérisé en ce que** le module de réseau (1) est relié de façon résistante à la traction au câble de pose (5).

4. Module de réseau (1) selon l'une des revendications précédentes, **caractérisé en ce que** le module de réseau (1) présente une aide de tirage.

5. Module de réseau (1) selon l'une des revendications précédentes comprenant un cadre de montage (2), **caractérisé en ce que** le module de réseau (1) peut être encliqueté dans le cadre de montage (2) et/ou vissé.

6. Module de réseau (1) selon l'une des revendications précédentes, **caractérisé en ce que** le module de réseau (1) supporte une alimentation en tension par le câble de pose (5).

7. Module de réseau (1) selon l'une des revendications précédentes, **caractérisé en ce que** le module de réseau (1) reçoit des conducteurs en cuivre et/ou des guides d'ondes optiques.

8. Module de réseau (1) selon l'une des revendications précédentes, **caractérisé en ce que** le module de réseau (1) présente un segment répartiteur.

9. Module de réseau (1) selon l'une des revendications précédentes, **caractérisé en ce qu'**au moins un module de réseau (1) forme une zone de connexion.

10. Module de réseau (1) selon l'une des revendications précédentes, **caractérisé en ce que** le module de réseau (1) présente un convertisseur de fluides.

11. Procédé pour l'installation d'un module de réseau (1) pré-confectionné, un câble de pose (5), qui est disposé sur le module de réseau (1), étant amené dans un chemin de câble en tirant sur le module de réseau (1).

12. Procédé selon la revendication 11, **caractérisé en ce que** le câble de pose (5), qui est disposé sur le module de réseau (1), est amené dans une périphérie de répartiteur (12) en tirant sur le module de réseau (1).

13. Procédé selon la revendication 11 ou 12, **caractérisé en ce que** le module de réseau (1) est amené au moyen d'une aide de tirage disposée sur le module de réseau (1) dans le chemin de câble et/ou la périphérie du répartiteur (12).

14. Procédé pour fabriquer un système de module de réseau (13), un câble de pose (5) étant relié sur au moins une extrémité de câble sans fiche à un module de réseau (1) selon l'une des revendications 1 à 10.

15. Utilisation d'un système de module de réseau (13), comprenant un câble de pose (5), sur au moins une extrémité du câble de pose (5) duquel un module de réseau (1) est disposé sans fiche selon l'une des revendications 1 à 10, le module de réseau présentant une aide de tirage, pour la mise en place d'une architecture de réseau.
